# EUROPÄISCHE PATENTSCHRIFT

(11) **EP 3 446 134 B1**
(45) Veröffentlichungstag und Bekanntmachung des Hinweises auf die Patenterteilung: **07.09.2022**
(21) Anmeldenummer: 17717706.0
(22) Anmeldetag: 13.04.2017
(51) Int. Cl.: G01R 19/155, G01R 31/68, B60L 3/12, B60L 3/00, G01R 31/00

(54) **BESTIMMUNG EINER ELEKTRISCHEN KONTAKTIERUNG EINES ELEKTRISCHEN SYSTEMS MIT EINEM MESSSYSTEM**
DETERMINING ELECTRICAL CONTACTING BETWEEN AN ELECTRICAL SYSTEM AND A MEASURING SYSTEM
DÉTERMINATION DE LA MISE EN CONTACT ÉLECTRIQUE D'UN SYSTÈME ÉLECTRIQUE AVEC UN SYSTÈME DE MESURE

(30) Priorität: 18.04.2016 AT 503392016
(43) Veröffentlichungstag der Anmeldung: 27.02.2019
(73) Patentinhaber: AVL DiTest GmbH, 8020 Graz (AT)
(72) Erfinder: HUBER, Christian, 8045 Graz (AT); RIEGLER, Roman, 6074 Rinn (AT)
(74) Vertreter: Patentanwälte Pinter & Weiss OG
(86) Internationale Anmeldenummer: PCT/EP2017/058987
(87) Internationale Veröffentlichungsnummer: WO 2017/182391

(56) Entgegenhaltungen:
- EP-A1- 2 487 496
- DE-A1-102011 004 288
- DE-A1-102012 200 722
- DE-B3-102013 009 802
- US-A1- 2007 176 604

## Beschreibung

Die vorliegende Erfindung betrifft ein Verfahren und eine Vorrichtung zum Bestimmen einer elektrischen Kontaktierung eines elektrischen Systems mit einem Messsystem, wobei das Messsystem über Messkontakte mit Messpunkten des elektrischen Systems verbindbar ist, wobei im Messsystem nach Schließen eines Entladeschalters, welcher eine Ladeschaltung mit einem Spannungsmessgerät verbindet, sich die Ladeschaltung über einen Innenwiderstand des Spannungsmessgeräts entlädt sowie die Verwendung der Vorrichtung.

Für Wartungsarbeiten an elektrischen Systemen muss die Spannungsfreiheit des elektrischen Systems festgestellt werden, bevor an diesem Arbeiten vorgenommen werden können. Das alleinige Trennen des elektrischen Systems vom elektrischen Versorgungsnetz oder von der elektrischen Energieversorgung ist noch keine sichere Grundlage, um Spannungsfreiheit festzustellen, da trotzdem elektrische Energie in elektrischen Energiespeichern, wie z.B. Kondensatoren, gespeichert sein kann. Zudem sind auch andere elektrostatische Aufladungen denkbar, die zu einer niedrigen Restspannung im elektrischen System führen können. Aber auch eine Spannungsmessung am elektrischen System garantiert noch keine Spannungsfreiheit, selbst dann nicht, wenn keine Spannung detektiert wird. Bedingt durch mögliche Kontaktierungsfehler der Messkontakte eines Messgeräts am Messobjekt, kann es zur fehlerhaften Anzeige der Spannungsfreiheit oder der Anzeige einer niedrigen Restspannung kommen, obwohl am Messobjekt sehr wohl noch eine (hohe) Spannung anliegen kann. Auch eine elektrostatische Aufladung im elektrischen System kann aufgrund des hochohmigen Eingangs eines Spannungsmessgerätes zu einer niedrigen Spannungsanzeige führen. Auch eine sehr niedrige Spannungsanzeige kann damit durch eine Fehlkontaktierung oder eine tatsächlich vorhandene Restspannung aus dem System herrühren.

Für eine sichere Feststellung der Spannungsfreiheit eines elektrischen Systems, um weiterführende Arbeiten am elektrischen System sicher durchführen zu können, ist daher eine Kontaktierungsprüfung der Messkontakte des Messgerätes erforderlich. Im Falle einer Fehlkontaktierung könnte eine niedrigere Spannung, im schlimmsten Fall gar keine Spannung, gemessen werden, als zwischen den Messstellen tatsächlich anliegt, was eine potentielle Gefahr für Personen darstellt, die am elektrischen System Arbeiten durchführen sollen. Herkömmliche Messgeräte bieten diese Funktion aber nicht. Daher wurde bisher die Kontaktierungsprüfung visuell durchgeführt. D.h., der Anwender prüft visuell, ob die Messkontakte das Messobjekt ordnungsgemäß kontaktieren. In vielen Anwendungen, z.B. bei Fahrzeugen mit elektrifizierten Antrieben, kann aber durch die engen Platzverhältnisse bzw. der Lage der Messstellen eine visuelle Kontrolle der Kontaktierung nicht bzw. nicht zweifelsfrei durchgeführt werden. Des Weiteren kann nicht immer von einer visuellen Kontaktierung auf eine tatsächliche elektrische Kontaktierung geschlossen werden.

Denkbar wäre zwar die oftmals in Messgeräten vorhandene Widerstandsmessung für eine Kontaktierungsüberprüfung einzusetzen. Dabei ist im Messgerät eine Strom- oder Spannungsquelle integriert und durch Messung des Stromflusses über die Messkontakte des Messgerätes kann auf eine kontaktierte Messstelle geschlossen werden. Allerdings kann damit nur ein rein ohmscher und zudem auch nur ein niederohmiger Widerstand detektiert werden. Ein Kontaktierungsfehler, was mit einem hochohmigen Widerstand gleichzusetzen ist, lässt sich auf diese Weise aber nicht sicher und zweifelsfrei feststellen. Außerdem könnte eine hohe Restspannung zu einer Zerstörung des Messgeräts führen, wenn sich dieses im Widerstandsmessmodus befindet.

Die DE 10 2012 200722 A1 beschreibt ein Verfahren zur Ermittlung einer erfolgten Kontaktierung eines Anschlusses. Dabei wird ein kapazitives Messsystem mit Messpunkten verbunden und eine Zeitkonstante des Messystems ermittelt. Die DE 10 2013 009802 B3 offenbart ein Verfahren zur Überprüfung einer Spannungsfreiheit einer Leistungselektronikeinheit eines Kraftfahrzeugs.

Es ist daher eine Aufgabe der gegenständlichen Erfindung, ein Messystem anzugeben, dass es ermöglicht auf einfache Weise zweifelsfrei festzustellen, ob Messkontakte, an denen eine Spannungsmessung durchgeführt werden soll, ordnungsgemäß kontaktiert wurden.

Diese Aufgabe wird gelöst, indem bei geschlossenem Entladeschalter nach einem Schließen eines Messschalters, welcher das Spannungsmessgerät mit den Messkontakten verbindet, die Kontaktierung des elektrischen Systems mit dem Messsystem bestimmt wird, indem der Spannungsverlauf am Spannungsmessgerät ab Schließen des Messschalters in einer Auswerteeinheit ausgewertet wird. Die Kontaktierung des elektrischen Systems kann beispielsweise vollständig, teilweise oder nicht vorhanden sein. Der Spannungsverlauf am Spannungsmessgerät kann ebenso durch eine Anzeigeeinheit angezeigt werden.

Eine Auswertung des Spannungsverlaufs ab Schließen des Messschalters kann beispielsweise die Detektion eines Sprungs sein, was z.B. mittels einer Differenzierung der Spannung erfolgen kann. Es könnte auch ein Soll-Spannungsverlauf gemessen und mit dem tatsächlichen Spannungsverlauf verglichen werden. Auch eine Integration des Spannungsverlaufs wäre eine Möglichkeit, usw.

Es kann jedoch vorteilhafterweise auch nach dem Schließen des Entladeschalters und vor dem Schließen des Messschalters ein charakteristischer Spannungsverlauf des Messsystems mittels des Spannungsmessgeräts aufgenommen werden. Der charakteristische Spannungsverlauf wird mit dem Spannungsverlauf nach dem Schließen des Messschalters verglichen, womit auf eine Kontaktierung geschlossen werden kann.

Die Entladung der Ladeschaltung erfolgt grundsätzlich über den Innenwiderstand des Spannungsmessegeräts. Es ist auch möglich den Entladevorgang über einen zum Spannungsmessgerät geschalteten Entladewiderstand zu beeinflussen, womit sich die Ladeschaltung auch über den Entladewiderstand entlädt. Dieser Entladewiderstand kann sowohl parallel als auch in Serie zum Spannungsmessgerät geschaltet sein. Im Falle einer Parallelschaltung wird der Gesamtwiderstand der Schaltung verkleinert und der Entladevorgang beschleunigt. Im Falle einer Serienschaltung wird der Gesamtwiderstand vergrößert, wodurch der Entladevorgang länger dauert. Ein Entladewiderstand in Serie hat jedoch auch den Effekt einer Strombegrenzung. Des Weiteren wird durch die Dimensionierung des Entladewiderstands die Zeitkonstante der Schaltung beeinflusst. Die Ladeschaltung hat in der Regel kapazitive Komponenten, eine Erhöhung des Schaltungswiderstands in Form einer Serienschaltung des Entladewiderstands erhöht die Zeitkonstante und senkt gleichermaßen den fließenden Strom. Dies kann einer Strombegrenzung dienen. Ein Parallelschalten des Entladewiderstands bewirkt eine Reduktion des Schaltungswiderstandes und damit eine geringere Zeitkonstante und somit ein schnelleres Ab- oder Aufklingen der zu messenden Spannung.

Vorteilhafterweise wird der Messschalter geschlossen, wenn eine Spannungsschwelle am Spannungsmessgerät unterschritten wird. Damit können beispielsweise durch Stromspitzen entstehende Schäden an empfindlicher Elektronik im Messsystem vermieden werden.

Die Ladeschaltung kann sich beispielsweise aus einer Spannungsquelle und einem parallel dazu angebrachten Kondensator zusammensetzen. Dabei kann ein Ladeschalter die Spannungsquelle mit dem Kondensator verbinden, wobei nach Schließen des Ladeschalters der Ladevorgang des Kondensators beginnt. Sobald daraufhin der Ladeschalter geöffnet wird, bleibt eine Ladung im Kondensator gespeichert. Der Kondensator kann in weiterer Folge erfindungsgemäß nach Schließen des Entladeschalters über das Spannungsmessgerät und nach Schließen des Messschalters bei erfolgreicher Kontaktierung über die Gesamtimpedanz der Zusammenschaltung aus Spannungsmessgerät und Messsystem entladen werden.

Es ist ferner möglich, die Vorrichtung derart zu verwenden, dass nach erfolgreicher Kontaktierung das Feststellen einer an den Messpunkten anliegenden Spannung erfolgt, vorteilhafterweise durch das in der Messschaltung vorhandene Spannungsmessgerät. Das Anliegen der Spannung an den Messpunkten kann nach oder während der Bestimmung der Kontaktierung aus dem Spannungsverlauf bestimmt werden.

Des Weitern kann der Wert dieser an den Messpunkten des elektrischen Systems anliegende Spannung gemessen werden. Vorteilhafterweise wird diese Spannungsmessung durch das in der Messschaltung vorhandene Spannungsmessgerät durchgeführt.

Die gegenständliche Erfindung wird nachfolgend unter Bezugnahme auf die Figuren 1 bis 4 näher erläutert, die beispielhaft, schematisch und nicht einschränkend, vorteilhafte Ausgestaltungen der Erfindung zeigen. Dabei zeigt
- Fig. 1: ein mit einem Messgerät verbundenes elektrisches System,
- Fig. 2: unterschiedliche Verläufe der Spannung U,
- Fig. 3: eine mögliche Ausgestaltung des Messgeräts.

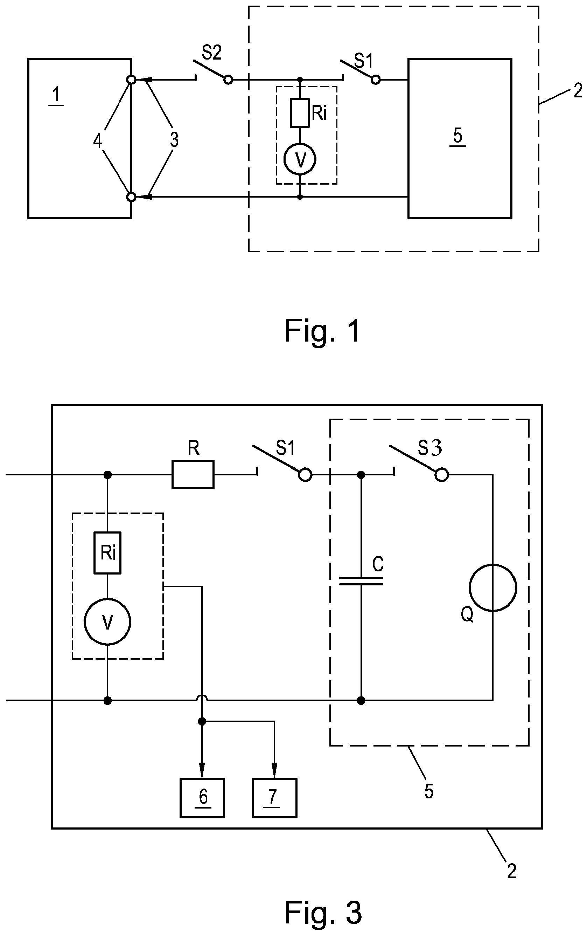

Anhand Fig.1 wird das grundlegende erfindungsgemäße Verfahren mit einem erfindungsgemäßen Messsystem 2 beschrieben. An einem elektrischen System 1, z.B. ein elektrisches Antriebssystem eines Hybridfahrzeugs, soll mit einem Messgerät 2 die Spannungsfreiheit festgestellt werden, bevor am elektrischen System 1 Arbeiten durchgeführt werden können. Dazu sind am elektrischen System 1 Messstellen 3, z.B. vorbereitete Messpunkte, vorgesehen, die zur Spannungsmessung einer allfällig anliegenden Spannung von den Messkontakten 4 des Messgeräts 2 zu kontaktieren sind. Im Messsystem 2 ist zur Spannungsmessung beispielsweise ein herkömmliches Spannungsmessgerät V mit Innenwiderstand Rᵢ vorgesehen (angedeutet in Fig.1). Zur sicheren Feststellung einer ordnungsgemäßen Kontaktierung besteht das Messgerät 2 neben dem Spannungsmessgerät V auch aus einer Ladeschaltung 5. Die Ladeschaltung 5 weist einen Ladungsspeicher zum Speichern elektrischer Ladung auf und kann daher beispielsweise eine Kapazität, einen elektrischen Energiespeicher, etc. darstellen. Natürlich kann eine beliebige andere Art von Energiequelle verwendet werden. Die Ladeschaltung 5 kann über einen Entladeschalter S1 auf das Spannungsmessgerät V geschaltet werden. Damit entlädt sich die Ladeschaltung 5 über den Innenwiderstand Rᵢ des Spannungsmessgeräts V, wobei das Spannungsmessgerät V den sich aus dem Innenwiderstand Rᵢ ergebenden charakteristischen Spannungsverlauf U_{char} des Messsystems 2 aufzeichnet. Der Entladeschalter S1 bleibt weiterhin geschlossen und in weiterer Folge wird der Messschalter S2 geschlossen, wodurch sich im Falle einer korrekten Kontaktierung der Messstellen 3 mit dem elektrischen System 1 die Impedanz des Gesamtsystems, bestehend aus Messsystem 2, d.h. Spannungsmessgerät V mit Innenwiderstand Rᵢ plus Ladeschaltung 5, und elektrischer Schaltung 2 ändert. Vom Verlauf der Spannung U am Spannungsmessgerät V vor und nach Schließen des Messschalters S2 kann auf eine korrekte Kontaktierung geschlossen werden.

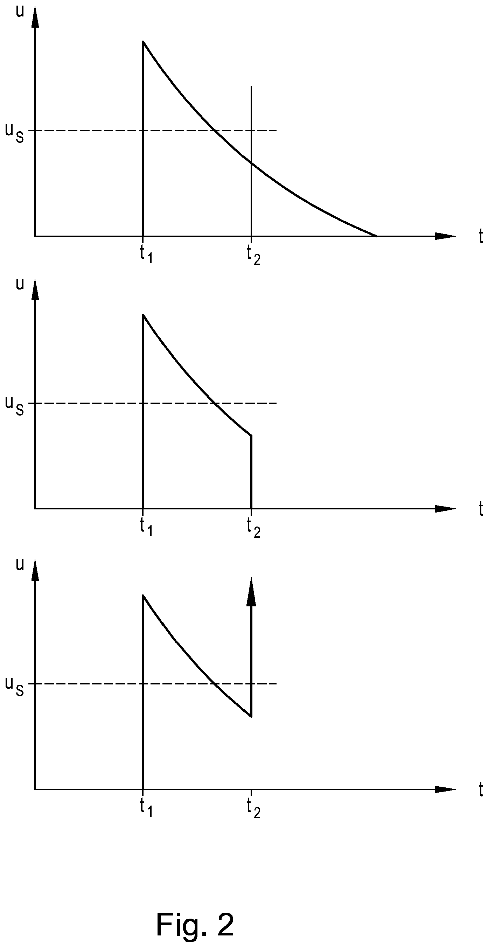

Der charakteristische Spannungsverlauf U_{char} ist in Fig. 2a dargestellt. Zum Zeitpunkt t₁ wird der Entladeschalter S1 geschlossen und die Spannungskurve klingt am Spannungsmessgerät ab. Ist das elektrische System 1 nicht kontaktiert, beispielsweise wenn ein Messkontakt 4 nicht oder nicht vollständig an der Messstelle 3 anliegt, so folgt der Verlauf der Spannung U am Spannungsmessgerät V nach Schließen des Messschalters S2 (in Fig. 1 zum Zeitpunkt t₂) weiterhin dem charakteristischen Spannungsverlauf U_{char} des Messsystems 2. Die Ladeschaltung 5 entlädt sich somit weiterhin lediglich über den Innenwiderstand Rᵢ des Spannungsmessgeräts V, es tritt kein Sprung des Spannungsverlaufs U auf.

Ist das elektrische System 1 kontaktiert, so wird das Messsystem 2, bestehend aus der Ladeschaltung 5 und dem Spannungsmessgerät V mit Innenwiderstand Rᵢ nach Schließen des Messschalters 2 um das elektrische System 1 erweitert. Durch diese Erweiterung wird die Impedanz des Messsystems 2 um die Impedanz des elektrischen Systems 1 erweitert und es ändert sich damit die Gesamtimpedanz, über die der Entladestrom fließt. Dies bewirkt auch eine Änderung des Spannungsverlaufs U am Spannungsmessgerät V, wie in Fig. 2b und Fig. 2c skizziert und weiter unten im Detail beschreiben wird. Somit kann auf eine erfolgreiche Kontaktierung geschlossen werden.

Vorteilhafterweise wird der Messschalter S2 geschlossen, wenn eine wie in Fig. 2 dargestellte Spannungsschwelle Uₛ am Spannungsmessgerät V nach Schließen des Entladeschalters S1 unterschritten wird. Damit können beispielsweise durch Stromspitzen entstehende Schäden an empfindlicher Elektronik im Messsystem 2 vermieden werden.

Zusätzlich zum Innenwiderstand Rᵢ des Spannungsmessgerätes V kann wie in der Fig. 3 dargestellt ein Entladewiderstand R verwendet werden, um den Spannungsverlauf U und damit auch den Verlauf der charakteristischen Spannung U_{char} des Messsystems 2, insbesondere eine Zeitkonstante, zu beeinflussen. Ein Parallelschalten des Entladewiderstandes R zum Spannungsmessgerät V bewirkt ein Reduzieren der Impedanz des Messsystems und damit ein Reduzieren der Zeitkonstante. Damit wird ein schnellerer Kurvenverlauf erreicht. Im Falle einer Serienschaltung des Entladewiderstands R zum Spannungsmessgerät V vergrößert sich zwar die Impedanz des Messsystems 2 und damit die Zeitkonstante, ebenso wird jedoch auch der maximale Strom reduziert, was einen Schutz für empfindliche elektronische Bauteile bewirkt.

Die Ladeschaltung kann wie in Fig.3 dargestellt beispielsweise als Spannungs- oder Stromquelle Q ausgeführt sein, die über einen Ladeschalter S3 parallel auf eine Kapazität C geschaltet werden kann. Nach Schließen des Ladeschalters S3 wird die Kapazität C geladen. Nachdem der Entladeschalter S1 daraufhin geöffnet wird, kann die geladene Kapazität erfindungsgemäß über das Spannungsmessgerät V entladen werden. Der Entladeschalter S1 kann auch geschlossen werden, wenn der Ladeschalter S3 noch geschlossen ist. Um eine Entladung der Ladeschaltung 5 sicherzustellen, sollte der Ladeschalter S3 jedoch immer bereits eine gewisse Zeit geöffnet sein, wenn das Messsystem 5 mit dem Messschalter S2 auf die elektrische Schaltung 1 geschaltet wird. Wenn der Entladevorgang der Ladeschaltung 5 nicht vor Schließen des Messschalters beginnt, wäre es nicht möglich den charakteristischen Spannungsverlauf U_{char} der Ladeschaltung 5 aufzunehmen, da das elektrische System die Gesamtimpedanz bereits geändert hätte.

Die durch das Spannungsmessgerät V gemessene Spannung kann in einer Auswerteeinheit 6 ausgewertet werden und kann an einer Anzeigeeinheit 7 angezeigt werden. Dazu kann die gemessene Spannung in der Auswerteeinheit natürlich auch in bekannter Weise digitalisiert werden.

Die Ausgangsimpedanz des elektrischen Systems 1, welches sich zwischen den Messkontakten 4 befindet, ist in der Regel gering. Somit fällt die Spannung U im Falle eines erfolgreich kontaktierten, jedoch zwischen den Messpunkten 3 spannungsfreien elektrischen Systems 1 nach Schließen des Messschalters S2 zum Zeitpunkt t₂ am Spannungsmessgerät V stark ab, wie in Fig. 2b dargestellt. Dies ergibt sich aus der gesunkenen Gesamtimpedanz, über die sich die Ladeschaltung 5 entlädt, zusammengesetzt aus elektrischem System 1 und der Messschaltung 2.

Ist das elektrische System 1 kontaktiert und elektrisch geladen, so steigt der Verlauf der Spannung U nach Schließen des Messschalters S2 zum Zeitpunkt t₂ am Spannungsmessgerät V stark an, wie in Fig. 2c zu sehen ist.

Somit kann nicht nur auf eine korrekte Kontaktierung geschlossen werden, sondern auch darauf, ob im Falle einer erfolgreichen Kontaktierung das elektrische System unter Spannung steht, oder spannungsfrei ist. Vorteilhafterweise wird zum Detektieren des Vorhandenseins einer Spannung an den Messpunkten 3 das Spannungsmessgerät V verwendet.

Das Verfahren und die Vorrichtung kann somit auch die an den Messpunkten 3 anliegende Spannung messen, was die Realisierung eines Spannungsmessmodus bzw. einer Spannungsmessvorrichtung entspricht.. Dazu kann nach Nachweis der erfolgreichen Kontaktierung und Detektion einer anliegenden Spannung der Entladeschalter S1 geöffnet werden um mit dem Spannungsmessgerät V die an den Messkontakten anliegende Spannung zu messen. Dieser Ablauf kann auch automatisiert durchgeführt werden, d.h. zuerst wird vor einer Spannungsmessung immer die korrekte Kontaktierung festgestellt und die Spannungsmessung erst dann durchgeführt, wenn die Kontaktierung erfolgte.

## Patentansprüche

1. Verfahren zum Bestimmen einer elektrischen Kontaktierung eines elektrischen Systems (1) mit einem Messsystem (2), wobei das Messsystem (2) über Messkontakte (3) mit Messpunkten (4) des elektrischen Systems (1) verbindbar ist, wobei im Messsystem (2) nach Schließen eines Entladeschalters (S1), welcher eine Ladeschaltung (5) mit einem Spannungsmessgerät (V) verbindet, sich die Ladeschaltung (5) über einen Innenwiderstand (Ri) des Spannungsmessgeräts (U) entlädt, **dadurch gekennzeichnet, dass** bei geschlossenem Entladeschalter (S1) nach einem Schließen eines Messschalters (S2), welcher das Spannungsmessgerät (V) mit den Messkontakten (3) verbindet, die Kontaktierung des elektrischen Systems (1) mit dem Messsystem (2) bestimmt wird, indem der Spannungsverlauf (U) am Spannungsmessgerät (V) ab Schließen des Messschalters (S2) ausgewertet wird.

2. Verfahren nach Anspruch 1, **dadurch gekennzeichnet, dass** nach dem Schließen des Entladeschalters (S1) und vor dem Schließen des Messschalters (S2) ein charakteristischer Spannungsverlauf (U_{char}) des Messsystems (2) mittels des Spannungsmessgeräts (V) aufgenommen wird, **und dass** der charakteristische Spannungsverlauf (U_{char}) mit dem Spannungsverlauf nach dem Schließen des Messschalters (S2) verglichen wird.

3. Verfahren nach Anspruch 1 oder 2, **dadurch gekennzeichnet, dass** sich die Ladeschaltung (5) nach Schließen des Entladeschalters (S1) über einen zum Spannungsmessgerät (V) in Serie oder parallel geschalteten Entladewiderstand (R) und den Innenwiderstand (Rᵢ) entlädt.

4. Verfahren nach Anspruch 1 oder 3, **dadurch gekennzeichnet, dass** der Messschalter (S2) geschlossen wird, wenn der charakteristische Spannungsverlauf (U_{char}) am Spannungsmessgerät (V) eine Spannungsschwelle (Us) unterschreitet.

5. Vorrichtung zum Bestimmen einer elektrischen Kontaktierung eines elektrischen Systems (1), wobei die Vorrichtung ein Messsystem (2) umfasst, wobei das Messsystem (2) über Messkontakte (3) mit Messpunkten (4) des elektrischen Systems (1) verbindbar ist, wobei im Messsystem (2) eine Ladeschaltung (5), ein Entladeschalter (S1) und ein Spannungsmessgerät (V) mit einem Innenwiderstand (Rᵢ) vorhanden sind, wobei der Entladeschalter (S1) in geschlossenem Zustand die Ladeschaltung (5) mit dem Spannungsmessgerät (V) verbindet, über den Innenwiderstand (Rᵢ) entlädt und damit das Spannungsmessgerät (V) einen charakteristischen Spannungsverlauf (U_{char}) des Messsystems (2) aufnimmt, **dadurch gekennzeichnet, dass** ein Messschalter (S2) und eine Auswerteeinheit (6) vorhanden sind, wobei der Messschalter (S2) das Spannungsmessgerät (V) mit den Messkontakten (3) verbindet, und die Auswerteeinheit (6) dazu dient, die Kontaktierung des elektrischen Systems (1) mit dem Messsystem (2) aus einem Spannungsverlauf (U) am Spannungsmessgerät (V) ab Schließen des Messschalters (S2) zu bestimmen.

6. Vorrichtung nach Anspruch 5, **dadurch gekennzeichnet, dass** ein Entladewiderstand (R) vorhanden ist, der zum Spannungsmessgerät (V) in Serie oder parallel geschaltet ist, sodass sich die Ladeschaltung (6) nach Schließen des Entladeschalters (S1) über den Entladewiderstand (R) und den Innenwiderstand (Ri) entlädt.

7. Vorrichtung nach Anspruch 5 oder 6, **dadurch gekennzeichnet, dass** die Ladeschaltung (5) aus einer Spannungsquelle (Q). einer Kapazität und einem Ladeschalter (S3) besteht, wobei die Spannungsquelle (Q) mit der Kapazität (C) und dem Ladeschalter (S3) in Serie verbunden ist, und die Spannungsquelle (Q) dazu vorgesehen ist, die Kapazität (C) nach Schließen des Ladeschalters (S3) zu laden.

8. Vorrichtung nach einem der Ansprüche 5 bis 7, **dadurch gekennzeichnet, dass** eine Anzeigeeinheit (7) vorgesehen ist, die den Verlauf der Spannung (U) am Spannungsmessgerät (V) darstellt.

9. Verwendung der Vorrichtung nach einem, der Ansprüche 5 bis 8, **dadurch gekennzeichnet, dass** nach erfolgreicher Kontaktierungsprüfung mit dem Spannungsmessgerät (V) festgestellt wird, ob eine elektrische Spannung an den Messpunkten (3) des elektrischen Systems (1) anliegt.

10. Verwendung nach Anspruch 9, **dadurch gekennzeichnet, dass** beim Feststellen des Vorhandenseins einer elektrischen Spannung an den Messpunkten (3) des elektrischen Systems (1) der Wert der elektrischen Spannung an den Messpunkten (3) ermittelt wird.

## Claims

1. Method for determining an electrical contacting of an electrical system (1) with a measurement system (2), the measurement system (2) being connectable to measurement points (4) of the electrical system (1) by means of measurement contacts (3), wherein in the measurement system (2), after a discharge switch (S1) connecting a charging circuit (5) to a voltage measurement device(V) is closed, the charging circuit (5) is discharged via an internal resistance (Ri) of the voltage measurement device(U), **characterized, in that,** when the discharge switch (S1) is closed, after a measurement switch (S2) connecting the voltage measurement device (V) to the measurement contacts (3) is closed, the contacting of the electrical system (1) is with the measurement system (2) is determined by analyzing the voltage curve (U) at the voltage measurement device (V) starting from closure of the measurement switch (S2).

2. Method according to claim 1, **characterized in that,** after the discharge switch (S1) is closed and before the measurement switch (S2) is closed, a characteristic voltage curve (U_{char}) of the measurement system (2) is recorded by means of the voltage measurement device (V), **and in that** the characteristic voltage curve (U_{char}) is compared with the voltage curve after the measurement switch (S2) is closed.

3. Method according to either claim 1 or claim 2, **characterized in that,** after the discharge switch (S1) is closed, the charging circuit (5) is discharged via a discharge resistor (R) connected in series or in parallel with the voltage measurement device (V) and via the internal resistance (Rᵢ).

4. Method according to either claim 1 or claim 3, **characterized in that** the measurement switch (S2) is closed when the characteristic voltage curve (U_{char}) drops below a voltage threshold (Us) at the voltage measurement device (V).

5. Device for determining an electrical contacting of an electrical system (1), whereas the device comprises a measurement system (2), the measurement system (2) being connectable to measurement points (4) of the electrical system (1) by means of measurement contacts (3), wherein a charging circuit (5), a discharge switch (S1) and a voltage measurement device (V) having an internal resistance (Rᵢ) are provided in the measurement system (2), the discharge switch (S1), when in the closed state, connecting the charging circuit (5) to the voltage measurement device (V), discharging said circuit via the internal resistance (Rᵢ) and the voltage measurement device (V) thus recording a characteristic voltage curve (U_{char}) of the measurement system (2), **characterized, in that** a measurement switch (S2) and an analysis unit (6) are present, the measurement switch (S2) connecting the voltage measurement device (V) to the measurement contacts (3), and the analysis unit (6) serves to determine the electrical contacting of the electrical system (1) with the measurement system (2) from a voltage curve (U) at the voltage measurement device (V) after closure of the measurement switch (S2).

6. Device according to claim 5, **characterized in that** a discharge resistor (R) is provided and is connected to the voltage measurement device (V) in series or in parallel such that the charging circuit (6) discharges via both the discharge resistor (R) and the internal resistance (Ri) after the discharge switch (S1) is closed.

7. Device according to either claim 5 or claim 6, **characterized in that** the charging circuit (5) consists of a voltage source (Q), a capacitor and a charging switch (S3), the voltage source (Q) being connected in series with the capacitor (C) and the charging switch (S3), and the voltage source (Q) being intended for charging the capacitor (C) after the charging switch (S3) is closed.

8. Device according to any of claims 5 to 7, **characterized in that** a display unit (7) is provided and shows the curve of the voltage (U) at the voltage measurement device (V).

9. Use of the device according to any of claims 5 to 8, **characterized in that,** after the contacting has been successfully checked, the voltage measurement device (V) is used to determine whether an electrical voltage is applied at the measurement points (3) of the electrical system (1).

10. Use according to claim 9, **characterized in that,** if it is determined that an electrical voltage is present at the measurement points (3) of the electrical system (1), the value of the electrical voltage at the measurement points (3) is ascertained.

## Revendications

1. Procédé pour la détermination d'une mise en contact électrique d'un système électrique (1) avec un système de mesure (2), le système de mesure (2) pouvant être connecté par le biais de contacts de mesure (3) à des points de mesure (4) du système électrique (1), dans lequel, dans le système de mesure (2), après la fermeture d'un commutateur de décharge (S1), lequel connecte un circuit de charge (5) à un voltmètre (V), le circuit de charge (5) se décharge à travers une résistance interne (Ri) du voltmètre (U), **caractérisé en ce que,** lorsque le commutateur de décharge (S1) est fermé, après la fermeture d'un commutateur de mesure (S2), lequel connecte le voltmètre (V) aux contacts de mesure (3), le contact du système électrique (1) avec le système de mesure (2) est déterminé, en évaluant la courbe de tension (U) au niveau du voltmètre (V) à partir de la fermeture du commutateur de mesure (S2).

2. Procédé selon la revendication 1, **caractérisé en ce que,** après la fermeture du commutateur de décharge (S1) et avant la fermeture du commutateur de mesure (S2), une courbe de tension caractéristique (U_{char}) du système de mesure (2) est enregistrée au moyen du voltmètre (V), et **en ce que** la courbe de tension caractéristique (U_{char}) est comparée à la courbe de tension après la fermeture du commutateur de mesure (S2).

3. Procédé selon la revendication 1 ou 2, **caractérisé en ce que** le circuit de charge (5), après la fermeture du commutateur de charge (S1), se décharge à travers une résistance de décharge (R) branchée en série ou en parallèle au voltmètre (V), et la résistance interne (Ri).

4. Procédé selon la revendication 1 ou 3, **caractérisé en ce que** le commutateur de mesure (S2) est fermé lorsque la courbe de tension caractéristique (U_{char}) au niveau du voltmètre (V) est inférieure à un seuil de tension (Us).

5. Dispositif pour la détermination d'une mise en contact électrique d'un système électrique (1), le dispositif comprenant un système de mesure (2), le système de mesure (2) pouvant être connecté par le biais de contacts de mesure (3) à des points de mesure (4) du système électrique (1), un circuit de charge (5), un commutateur de décharge (S1) et un voltmètre (V) comprenant une résistance interne (Ri) étant présents dans le système de mesure (2), le commutateur de décharge (S1) connectant, à l'état fermé, le circuit de charge (5) au voltmètre (V), le déchargeant à travers la résistance interne (Ri) et le voltmètre (V) enregistrant ainsi une courbe de tension caractéristique (U_{char}) du système de mesure (2), **caractérisé en ce qu'**un commutateur de mesure (S2) et une unité d'évaluation (6) sont présents, le commutateur de mesure (S2) connectant le voltmètre (V) aux contacts de mesure (3) et l'unité d'évaluation (6) servant à déterminer la mise en contact du système électrique (1) au système de mesure (2) à partir d'une courbe de tension (U) au niveau du voltmètre (V) à partir de la fermeture du commutateur de mesure (S2).

6. Dispositif selon la revendication 5, **caractérisé en ce qu'**une résistance de décharge (R) est présente, laquelle est branchée en série ou en parallèle au voltmètre (V), de telle sorte que le circuit de charge (6) se décharge à travers la résistance de décharge (R) et la résistance interne (Ri) après la fermeture du commutateur de décharge (S1).

7. Dispositif selon la revendication 5 ou 6, **caractérisé en ce que** le circuit de charge (5) se compose d'une source de tension (Q), d'une capacité et d'un commutateur de charge (S3), la source de tension (Q) étant connectée en série à la capacité (C) et au commutateur de charge (S3), et la source de tension (Q) étant prévue pour charger la capacité (C) après la fermeture du commutateur de charge (S3).

8. Dispositif selon l'une quelconque des revendications 5 à 7, **caractérisé en ce qu'**une unité d'affichage (7) est prévue, laquelle représente la courbe de la tension (U) au niveau du voltmètre (V).

9. Utilisation du dispositif selon l'une quelconque des revendications 5 à 8, **caractérisée en ce que,** après un contrôle de mise en contact réussi, il est déterminé avec le voltmètre (V) si une tension électrique est appliquée aux points de mesure (3) du système électrique (1).

10. Utilisation selon la revendication 9, **caractérisée en ce que,** lors de la détermination de la présence d'une tension électrique aux points de mesure (3) du système électrique (1), la valeur de la tension électrique aux points de mesure (3) est déterminée.
